# EUROPÄISCHE PATENTANMELDUNG

(11) **EP 1 501 123 A2**
(43) Veröffentlichungstag der Anmeldung: **26.01.2005**
(21) Anmeldenummer: 04017011.0
(22) Anmeldetag: 19.07.2004
(51) Int. Cl.: H01L 21/768

(54) **Haftung von Strukturen mit einem schlecht haftenden Material**

(30) Priorität: 25.07.2003 DE 10334124
(71) Anmelder: Infineon Technologies AG, 81669 München (DE)
(72) Erfinder: Ruttkowski, Eike, 81677 München (DE); Hofman, Franz, Dr. rer. nat., 80995 München (DE); Eversmann, Björn-Oliver, Dipl. Ing., 80336 München (DE)
(74) Vertreter: Müller-Boré & Partner Patentanwälte

(57) **Zusammenfassung**

Die vorliegende Erfindung betrifft eine elektronische Vorrichtung, insbesondere eine Halbleitervorrichtung, umfassend ein Substrat (1), mindestens einen auf einem Teil des Substrats abgeschiedenen Haftvermittlerkern (2) aus z.B. Ti, Cr, Zr oder Hf und eine den Haftvermittlerkern vollständig umschließende Abscheidung (3) aus einem schlecht haftenden Material aus z.B. Au, Ag, Pt oder Pd, das von dem Haftvermittlermaterial verschieden ist und mit dem Substrat in direktem Kontakt steht, sowie Verfahren zu deren Herstellung.

## Beschreibung

Die vorliegende Erfindung betrifft eine elektronische Vorrichtung, insbesondere eine Halbleitervorrichtung, umfassend ein Substrat, mindestens einen auf einem Teil des Substrats abgeschiedenen Haftvermittlerkern und eine den Haftvermittlerkern vollständig umschließende Abscheidung aus einem schlecht haftenden Material, das von dem Haftvermittlermaterial verschieden ist und mit dem Substrat in direktem Kontakt steht, sowie Verfahren zu deren Herstellung.

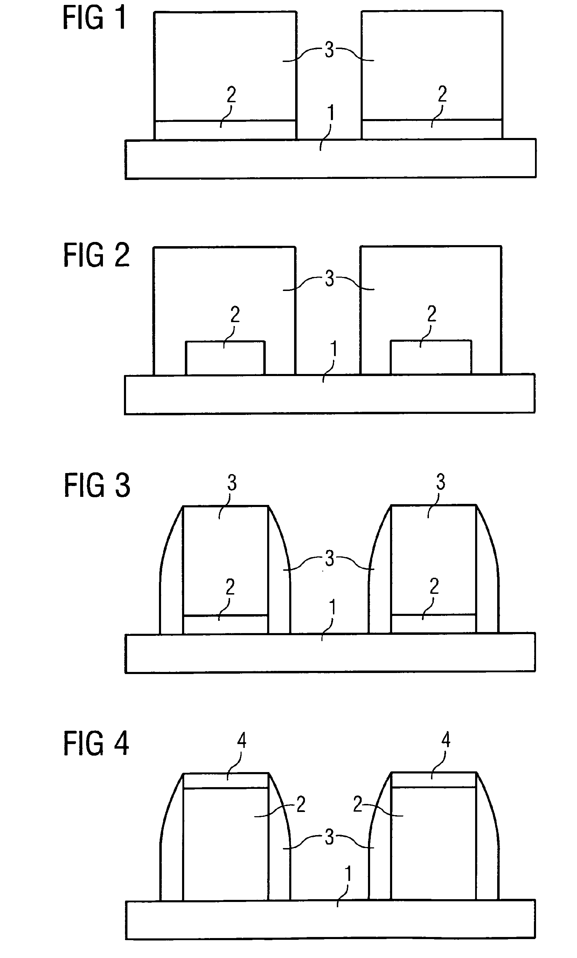

Im Stand der Technik sind elektronische Vorrichtungen bekannt, welche die Haftung einer Struktur aus einem schlecht haftenden Material, wie z.B. Silber oder Platin, die insbesondere als Leiterbahnmaterial eingesetzt werden, auf einem Substrat, wie Si oder SiO₂, durch Anordnen einer Haftvermittlerschicht sicherstellen, die über die gesamte Kontaktfläche zwischen der Struktur aus dem schlecht haftenden Material und dem Substrat aufgebracht wird (vgl. Figur 1). Eine derartige Vorrichtung weist aber den Nachteil auf, daß das schlecht haftende Material nicht in direktem Kontakt mit dem Substrat steht, sondern durch den Haftvermittler getrennt ist, und die Flanken des Haftvermittlers freiliegen und somit, abhängig von dessen ausgewähltem Material, beispielsweise oxidationsempfindlich sein können.

Vor diesem Hintergrund ist es eine Aufgabe der vorliegenden Erfindung, eine elektronische Vorrichtung bereitzustellen, die sowohl eine gute Haftung eines schlecht haftenden Materials auf einem Substrat als auch einen direkten Kontakt zwischen diesem schlecht haftenden Material und dem Substrat ermöglichen soll, ohne daß ein Haftvermittler über die gesamte Kontaktfläche zwischen der Struktur aus dem schlecht haftenden Material und dem Substrat angeordnet werden muß.

Diese Aufgabe wird durch die in den Ansprüchen gekennzeichneten Ausführungsformen gelöst.

Insbesondere stellt die vorliegende Erfindung eine elektronische Vorrichtung bereit, umfassend ein Substrat, mindestens einen auf einem Teil des Substrats abgeschiedenen Haftvermittlerkern und eine den Haftvermittlerkern vollständig umschließende Schicht bzw. Abscheidung aus einem schlecht haftenden Material, das von dem Haftvermittlermaterial verschieden ist und mit dem Substrat in direktem Kontakt steht.

Unter einem Haftvermittlerkern bzw. einer Haftvermittlerstruktur (in beliebiger Form) wird im Rahmen der vorliegenden Erfindung eine auf einem Substrat abgeschiedene Struktur, beispielsweise eine durch Sputtern oder Aufdampfen gebildete Struktur im Nanometerbereich, verstanden, die eine kleinere Dimension bzw. Abmessung bzw. Strukturgröße als die diese umschließende Abscheidung aus dem schlecht haftenden Material aufweist. Ein Haftvermittlerkern weist insbesondere die Eigenschaft auf, die Haftung zwischen einem Substrat, beispielsweise Si oder SiO₂, und einem darauf schlecht bzw. ungenügend haftenden Material, beispielsweise Edelmetalle, die insbesondere als Leiterbahnmaterial zum Einsatz kommen, signifikant zu verbessern.

Im Rahmen der vorliegenden Erfindung wurde festgestellt, daß sich bei Anordnen eines Haftvermittlerkerns mit einer kleineren Strukturgröße im Vergleich zu dem darüber abgeschiedenen, schlecht haftenden Material in vorteilhafter Weise eine ausgezeichnete Haftfähigkeit zwischen dem von dem Haftvermittlermaterial verschiedenen Material und dem Substrat

### (1) erreichen läßt.

Üblicherweise umfassen elektronische Anordnungen eine Vielzahl solcher einzelner erfindungsgemäßer Vorrichtungen. Dabei ist es wesentlich, daß die Haftvermittlerkerne, die von der Schicht aus dem schlecht haftenden Material umschlossen sind, räumlich voneinander getrennt sind, d.h. nicht miteinander in Kontakt, beispielsweise in räumlichem Kontakt oder leitendem Kontakt, stehen. In der Regel sind die umschlossenen Haftvermittlerkerne derart räumlich voneinander getrennt, daß das Substrat zwischen den umschlossenen Haftvermittlerkernen freiliegt oder unbedeckt ist. Der Abstand der Haftvermittlerkerne auf dem Substrat unterliegt keiner besonderen Beschränkung, er liegt jedoch üblicherweise im Mikrometer- oder Nanometerbereich. Vorzugsweise liegt der Abstand der umschlossenen Haftvermittlerkerne in lateraler Richtung (bezogen auf deren Strukturränder bzw. -kanten) in einem Bereich von 20 nm bis 200 nm.

Gemäß einer Ausführungsform der vorliegenden Erfindung ist der Haftvermittlerkern vollständig von dem schlecht haftenden Material umschlossen. Damit kann unter Sicherstellung einer verbesserten Haftung ein sehr wirkungsvoller direkter Kontakt zwischen der Schicht bzw. Umhüllung aus dem von dem Haftvermittlermaterial verschiedenen, schlecht haftenden Material und dem Substrat erreicht werden.

Gemäß einer anderen Ausführungsform der vorliegenden Erfindung wird eine elektronische Vorrichtung bereitgestellt, umfassend ein Substrat, mindestens einen auf einem Teil des Substrats abgeschiedenen Haftvermittlerkern mit einer an dessen Flanken bzw. Seitenflächen angeordneten Schicht bzw. Abscheidung aus einem schlecht haftenden Material, das von dem Haftvermittlermaterial verschieden ist und mit dem Substrat in direktem Kontakt steht, und eine aus einem Reaktionsprodukt des Haftvermittlermaterials gebildete Schicht auf der dem Substrat abgewandten bzw. gegenüberliegenden Oberfläche bzw. Seite des Haftvermittlerkerns, so daß die aus einem Reaktionsprodukt des Haftvermittlermaterials gebildete Schicht und die Abscheidung aus dem schlecht haftenden Material den auf dem Substrat angeordneten Haftvermittlerkern vollständig umschließen bzw. umgeben bzw. einbetten.

Das Reaktionsprodukt des Haftvermittlermaterials kann grundsätzlich jedes aus dem Haftvermittlermaterial und einer damit reaktiven Verbindung erhältliche Reaktionsprodukt sein. Vorzugsweise ist das Reaktionsprodukt des Haftvermittlermaterials ein Oxid des Haftvermittlermaterials, das in einer Sauerstoff-haltigen Atmosphäre gebildet wird.

Das in der vorliegenden Erfindung verwendbare Substrat unterliegt keiner spezifischen Beschränkung. Geeignete Substrate können daher beispielsweise Metalle, Halbleiter, Oxid- und Nitridverbindungen, Glas, Polymere, etc., sein. Im Rahmen der vorliegenden Erfindung werden vorzugsweise Halbleitersubstrate eingesetzt, wobei das Substrat besonders bevorzugt aus Si oder SiO₂ ausgewählt ist.

Die Form des Substrats unterliegt keiner besonderen Beschränkung. Vorzugsweise ist das Substrat planar bzw. eben. Die Dicke des Substrats unterliegt ebenfalls keiner spezifischen Beschränkung und ist üblicherweise von der gewünschten Verwendung abhängig.

Das Haftvermittlermaterial ist ein Material, das geeignet ist, eine gute Haftung zwischen dem Substrat und einem üblicherweise als Leiterbahnmaterial eingesetztem Material zu liefern. Geeignete Haftvermittlermaterialien sind einem Fachmann auf diesem Gebiet bekannt und können ohne größere Mühe ausgewählt werden. Besonders bevorzugte Haftvermittlermaterialien sind Ti, Cr, Zr oder Hf oder Gemische bzw. Legierungen davon.

Das den Haftvermittlerkern umschließende, schlecht haftende Material ist vorzugsweise ein Edelmetall, wie Au, Ag, Pd oder Pt oder eine Legierung oder Gemische davon.

Die Dicke (Schichtdicke) des Haftvermittlerkerns kann in einem Bereich von 10 nm bis 200 nm liegen, wobei eine Dicke in einem Bereich von 30 nm bis 60 nm bevorzugt ist und eine Dicke von etwa 50 nm besonders bevorzugt ist.

Die Dicke der Schicht bzw. Abscheidung aus dem von dem Haftvermittlermaterial verschiedenen, schlecht haftenden Material kann, bezogen auf den Abstand von der Substratoberfläche, in einem Bereich von 10 nm bis 1000 nm liegen, wobei eine Dicke in einem Bereich von 50 nm bis 800 nm bevorzugt und eine Dicke von 100 nm bis 500 nm besonders bevorzugt ist.

Die Strukturbreite bzw. laterale Dimensionierung des Haftvermittlerkerns kann, je nachdem welches Lithographieverfahren angewendet wird, in einem Bereich von 15 nm bis 350 nm liegen. Die Strukturbreite des von einer Schicht bzw. Abscheidung des von dem Haftvermittlermaterial verschiedenen, schlecht haftenden Materials umschlossenen Haftvermittlerkerns kann in einem Bereich von 20 nm bis 300 nm liegen.

Die Dicke der Schicht aus dem Reaktionsprodukt des Haftvermittlermaterials kann in einem Bereich von 10 nm bis 200 nm liegen, wobei eine Dicke von 10 nm bis 50 nm bevorzugt ist.

Ferner stellt die vorliegende Erfindung ein Verfahren zur Herstellung einer Vorrichtung, wie vorstehend definiert, bereit, umfassend die Schritte:
(i) Bereitstellen eines Substrats,
(ii) Anordnen mindestens eines Haftvermittlerkerns auf dem Substrat und
(iii) Abscheiden des schlecht haftenden Materials, das von dem Haftvermittlermaterial verschieden ist, derart über den Haftvermittlerkern auf das Substrat, daß der Haftvermittlerkern von einer Schicht aus dem schlecht haftenden Material umschlossen wird.

In einer Ausführungsform des vorstehenden Verfahrens können die Schritte (ii) und (iii) unter Verwendung unterschiedlicher Strukturmasken durchgeführt werden, wobei die Strukturmaskengröße in Schritt (ii) kleiner als diejenige in Schritt (iii) gewählt wird (vgl. Figur 2).

In einer anderen Ausführungsform des vorstehenden Verfahrens können die Schritte (ii) und (iii) unter Verwendung der gleichen Strukturmasken durchgeführt werden, wobei dann nach Schritt (iii) mit Hilfe einer konformen Abscheidung weiter schlecht haftendes Material abgeschieden wird, so daß dadurch auch an den Seitenflächen bzw. Flankenseiten eine Schicht aus schlecht haftendem Material, ein sogenannter Spacer aus schlecht haftendem Material, gebildet wird. Anschließend kann beispielsweise durch anisotropes Ätzen, wie Reaktives Ionenätzen, schlecht haftendes Material derart selektiv entfernt werden, daß sich eine wie in Figur 3 dargestellte Struktur ausbildet. Unter konformer Abscheidung wird dabei eine Abscheidung verstanden, bei der sich die zu erzeugende Schicht an vertikalen Strukturkanten mit der gleichen Rate wie an horizontalen Oberflächen bildet; vgl. U. Hilleringmann, Silizium-Halbleitertechnologie, Teubner-Verlag, 1996, Kapitel 7.1.2..

Der Schritt des Anordnens bzw. Strukturierens eines Haftvermittlerkerns auf dem Substrat in Schritt (ii) kann durch Lift-Off-Technik oder durch Ätztechnik, beispielsweise durch Trockenätzen oder durch Reaktives Ionenätzen, erfolgen. Bei der Lift-Off-Technik geht man von einem Substrat mit einem darauf vorgesehenen üblicherweise verwendeten Resistfilm aus und führt beispielsweise eine Photolithographie oder eine Elektronenstrahllithographie, etc., mit einer geeignet ausgewählten Maske durch. Anschließend wird nicht gehärtetes Resistmaterial durch Lösen in einem geeigneten Lösungsmittel entfernt und ein Aufdampfschritt wird durchgeführt, in dem das Haftvermittlermaterial in einer gewünschten Dicke aufgebracht wird. Danach werden die Stege aus gehärtetem Resistmaterial und Haftvermittlermaterial abgelöst, wobei sich eine gewünschte Struktur aus Haftvermittlerkernen auf dem Substrat ausbildet. Bei der Ätztechnik, beispielsweise der Technik des reaktiven Ionenätzens (RIE-Technik), geht man von einem mit Haftvermittlermaterial bedampftem Substrat mit einem darauf aufgebrachten Film aus einem üblicherweise verwendeten Resist aus. Anschließend werden beispielsweise durch Elektronenstrahllithographie oder Photolithographie unter Verwendung einer geeignet ausgewählten Maske bestimmte Bereiche des Resistfilms gehärtet und die nicht gehärteten Bereiche werden mit einem geeigneten Lösungsmittel entfernt. An den von einem Resistfilm befreiten Stellen wird ein Ätzen von Löchern bis zur Tiefe des Substrats durchgeführt, wobei das Ätzmittel vorzugsweise derart ausgewählt wird, daß es das Substrat nicht oder nur kaum angreift.

Mittels der vorstehend beschriebenen Verfahren lassen sich Haftvermittlerkerne im Mikrometer- oder Nanometerbereich auf dem Substrat, beispielsweise mit einer Auflösung in einem Bereich von 20 nm bis 200 nm, herstellen. Demgemäß ist die Auflösung der gewünschten Haftvermittler(kern)-Strukturen auf dem Substrat nur durch das Lithographielimit begrenzt.

Das Aufbringen des Haftvermittlermaterials bzw. des von dem Haftvermittlermaterial verschiedenen, schlecht haftenden Materials auf das Substrat kann durch jedes auf dem Fachgebiet übliche Verfahren erfolgen. Vorzugsweise erfolgt das Aufbringen des Haftvermittlermaterials bzw. des von dem Haftvermittlermaterial verschiedenen, schlecht haftenden Materials durch Sputtertechniken bzw. Atomic Layer Deposition-Verfahren (ALD-Verfahren) und, sofern keine konforme Abscheidung vorgesehen wird, z.B. durch Aufdampftechniken.

Das Strukturieren des von dem Haftvermittlermaterial verschiedenen, schlecht haftenden Materials unter Ausbildung einer den Haftvermittlerkern umschließenden Schicht bzw. Abscheidung in Schritt (iii) kann ebenfalls durch Lift-Off-Technik oder durch Ätztechnik, wie vorstehend beschrieben, unter Verwendung einer geeigneten Maske erfolgen. Bei Anwendung der Lift-Off-Technik geht man in Schritt (iii) von einem Substrat mit bereits darauf strukturierten Haftvermittlerkernen, wie vorstehend unter Schritt (ii) beschrieben, aus, trägt einen üblicherweise verwendeten Resistfilm auf und führt beispielsweise eine Photolithographie oder eine Elektronenstrahllithographie, etc., mit einer geeignet ausgewählten Maske durch. Anschließend wird nicht gehärtetes Resistmaterial durch Lösen in einem geeigneten Lösungsmittel entfernt und das von dem Haftvermittlermaterial verschiedene, schlecht haftende Material in einer gewünschten Dicke aufgebracht. Danach werden die Stege aus gehärtetem Resistmaterial und dem von dem Haftvermittlermaterial verschiedenen, schlecht haftenden Material abgelöst, so daß eine gewünschte Struktur, wie in Figur 2 gezeigt, erzeugt wird. Bei Anwendung der Ätztechnik, beispielsweise der Technik des reaktiven Ionenätzens (RIE-Technik), geht man in Schritt (iii) von einem Substrat mit bereits darauf strukturierten Haftvermittlerkernen, wie vorstehend beschrieben, aus und bringt ein von dem Haftvermittlermaterial verschiedenes, schlecht haftendes Material in einer geeigneten Dicke auf. Anschließend wird ein Film aus einem üblicherweise verwendeten Resist aufgebracht und das Resistmaterial in gewünschter Weise gehärtet, beispielsweise durch Elektronenstrahllithographie oder Photolithographie, unter Verwendung einer geeignet ausgewählten Maske, wobei vorbestimmte Bereiche des Resitfilms gehärtet werden. Die nicht gehärteten Bereiche des Resistfilms, die im wesentlichen den Bereichen zwischen den Haftvermittlerkernen bzw. den umschlossenen Haftvermittlerkernen entsprechen, werden mit einem geeigneten Lösungsmittel entfernt. An den von einem Resistfilm befreiten Stellen, die im wesentlichen den Bereichen zwischen den Haftvermittlerkernen bzw. den umschlossenen Haftvermittlerkernen entsprechen, wird ein Ätzen von Löchern, vorzugsweise bis zur Tiefe des Substrats durchgeführt, wobei das Ätzmittel vorzugsweise derart ausgewählt wird, daß es das Substrat nicht oder nur kaum angreift. Durch das vorstehend beschriebene Verfahren läßt sich ebenfalls eine wie in Figur 2 gezeigte Struktur erzeugen.

Gemäß einer weiteren Ausführungsform stellt die vorliegende Erfindung ein Verfahren zur Herstellung einer Vorrichtung, wie vorstehend definiert, bereit, umfassend die Schritte:
(i) Bereitstellen eines Substrats,
(ii) Anordnen mindestens eines Haftvermittlerkerns auf dem Substrat,
(iii) Abscheiden des schlecht haftenden Materials, das von dem Haftvermittlermaterial verschieden ist, derart über den Haftvermittlerkern auf das Substrat, daß der Haftvermittlerkern von einer Schicht aus dem schlecht haftenden Material umschlossen wird,
(iv) selektives Entfernen des schlecht haftenden Materials an der dem Substrat abgewandten Seite des Haftvermittlerkerns, so daß das Haftvermittlermaterial an der dem Substrat abgewandten Seite freigelegt wird,
(v) Umsetzen des in Schritt (iv) freigelegten Haftvermittlermaterials an der dem Substrat abgewandten Seite in einer reaktiven Atmosphäre unter Ausbildung einer Schicht aus einem Reaktionsprodukt des Haftvermittlermaterials.

Üblicherweise wird bei einer solchen Ausführungsform zunächst auf dem Substrat, wie Si oder SiO₂, eine Haftvermittlerschicht abgeschieden und strukturiert. Nach der Strukturierung wird mit Hilfe einer konformen Abscheidung an den Seitenflächen bzw. Flankenseiten eine Schicht aus schlecht haftendem Material, ein sogenannter Spacer aus schlecht haftendem Material, gebildet. Der Schritt des selektiven bzw. bereichsweisen Entfernens des von dem Haftvermittlermaterial verschiedenen, schlecht haftenden Materials an der dem Substrat abgewandten Seite des Haftvermittlerkerns, wobei das Haftvermittlermaterial an der dem Substrat abgewandten Seite freigelegt wird (Schritt (*iv*)), kann durch (Rück)ätzen bzw. anisotropes Ätzen, wie Reaktives Ionenätzen, erfolgen. Bei dem (Rück)ätzen wird aufgrund der ungleich fortschreitenden Ätzfront eines geeigneten Ätzmittels eine Struktur ausgebildet, bei der ein Haftvermittlerkern auf dem Substrat verbleibt, der nur an den Flanken bzw. an der Seite des Haftvermittlerkerns das von dem Haftvermittlermaterial verschiedene, schlecht haftende Material aufweist. Mittels dieses selektiven Ätzschritts kann die dem Substrat abgewandte Seite des Haftvermittlermaterials gezielt freigelegt werden und beispielsweise in einer reaktiven Atmosphäre zu einer Schicht aus einem Reaktionsprodukt des Haftvermittlermaterials umgesetzt werden (vgl. Figur 4). Das Reaktionsprodukt des Haftvermittlermaterials kann grundsätzlich jedes aus dem Haftvermittlermaterial und einer damit reaktiven Verbindung erhältliche Reaktionsprodukt sein. Vorzugsweise ist das Reaktionsprodukt des Haftvermittlermaterials ein in einer Sauerstoff-haltigen Atmosphäre gebildetes Oxid des Haftvermittlermaterials, d.h. das Haftvermittlermaterial wird thermisch oxidiert.

Der spezifische Aufbau der erfindungsgemäßen Vorrichtungen, d.h. deren Querschnitt, kann mittels REM-Untersuchung nachgewiesen werden.

Die Figuren zeigen:
Figur 1 zeigt den Querschnitt einer Vorrichtung gemäß dem Stand der Technik, umfassend ein Substrat (1), einen darauf abgeschiedenen Haftvermittlerkern (2) und eine Schicht bzw. Abscheidung (3) aus einem von dem Haftvermittlermaterial verschiedenen, schlecht haftenden Material. Die Abscheidung (3) steht nicht in direktem Kontakt mit dem Substrat (1). Die Flanken des Haftvermittlerkerns (2) liegen offen.
Figur 2 zeigt den Querschnitt einer erfindungsgemäßen Vorrichtung, umfassend ein Substrat (1), einen darauf abgeschiedenen Haftvermittlerkern (2) und eine den Haftvermittlerkern (2) umschließende Schicht bzw. Abscheidung (3) aus einem von dem Haftvermittlermaterial verschiedenen, schlecht haftenden Material, die mit dem Substrat in direktem Kontakt steht. Zur Herstellung dieser Vorrichtung wurde die Strukturgröße des Haftvermittlerkerns kleiner als die des schlecht haftenden Materials gewählt.
Figur 3 zeigt den Querschnitt einer erfindungsgemäßen Vorrichtung, umfassend ein Substrat (1), einen darauf abgeschiedenen Haftvermittlerkern (2) und eine den Haftvermittlerkern (2) umschließende Schicht bzw. Abscheidung (3) aus einem von dem Haftvermittlermaterial verschiedenen, schlecht haftenden Material, die mit dem Substrat in direktem Kontakt steht. Zur Strukturierung des Haftvermittlerkerns und der Schicht aus schlecht haftendem Material wurde die gleiche Maske verwendet, so daß durch die Verwendung von nur einer Maske das Lithographielimit nutzbar ist. Nach der Strukturierung wird mittels einer konformen Abscheidung ein Spacer aus schlecht haftendem Material erzeugt; vgl. die schematisch angedeuteten Flankenflächen in Figur 3.
Figur 4 zeigt den Querschnitt einer erfindungsgemäßen Vorrichtung, umfassend ein Substrat (1), einen darauf abgeschiedenen Haftvermittlerkern (2) mit einer den Haftvermittlerkern an den Flanken umschließenden, mittels konformer Abscheidung erzeugten Schicht bzw. Abscheidung (3) aus einem von dem Haftvermittlermaterial verschiedenen, schlecht haftenden Material, die mit dem Substrat in direktem Kontakt steht, und eine aus einem Reaktionsprodukt des Haftvermittlermaterials gebildete Schicht (4) an der dem Substrat abgewandten Seite des Haftvermittlerkerns.

### Bezugszeichenliste

- **1**: Substrat
- **2**: Haftvermittlerkern
- **3**: Abscheidung aus einem von dem Haftvermittlermaterial verschiedenen, schlecht haftenden Material
- **4**: Schicht aus einem Reaktionsprodukt des Haftvermittlermaterials

## Patentansprüche

1. Elektronische Vorrichtung, umfassend ein Substrat (1), mindestens einen auf einem Teil des Substrats (1) abgeschiedenen Haftvermittlerkern (2) und eine den Haftvermittlerkern (2) vollständig umschließende Abscheidung (3) aus einem schlecht haftenden Material, das von dem Haftvermittlermaterial verschieden ist und mit dem Substrat (1) in direktem Kontakt steht.

2. Elektronische Vorrichtung, umfassend ein Substrat (1), mindestens einen auf einem Teil des Substrats (1) abgeschiedenen Haftvermittlerkern (2) mit einer an dessen Seitenflächen angeordneten Abscheidung aus einem schlecht haftenden Material, das von dem Haftvermittlermaterial verschieden ist und mit dem Substrat (1) in direktem Kontakt steht, und eine aus einem Reaktionsprodukt des Haftvermittlermaterials gebildete Schicht (4) an der dem Substrat (1) abgewandten Seite des Haftvermittlerkerns (2), so daß die aus einem Reaktionsprodukt des Haftvermittlermaterials gebildete Schicht (4) und die Abscheidung (3) aus dem schlecht haftenden Material den auf dem Substrat angeordneten Haftvermittlerkern (2) vollständig umschließen.

3. Vorrichtung nach Anspruch 1 oder 2, wobei das Haftvermittlermaterial Ti, Cr, Zr oder Hf oder ein Gemisch bzw. eine Legierung davon ist.

4. Vorrichtung nach einem oder mehreren der vorhergehenden Ansprüche, wobei das von dem Haftvermittlermaterial verschiedene, schlecht haftende Material aus Au, Ag, Pt und Pd oder einem Gemisch bzw. einer Legierung davon ausgewählt ist.

5. Vorrichtung nach einem oder mehreren der vorhergehenden Ansprüche, wobei das Substrat (1) Si oder SiO₂ ist.

6. Vorrichtung nach einem oder mehreren der vorhergehenden Ansprüche 2 bis 5, wobei das Reaktionsprodukt des Haftvermittlermaterials ein Oxid des Haftvermittlermaterials ist.

7. Verfahren zur Herstellung einer elektronischen Vorrichtung nach einem oder mehreren der vorhergehenden Ansprüche 1, 3, 4 und 5, umfassend die Schritte:
(i) Bereitstellen eines Substrats (1),
(ii) Anordnen mindestens eines Haftvermittlerkerns (2) auf dem Substrat (1) und
(iii) Abscheiden des schlecht haftenden Materials, das von dem Haftvermittlermaterial verschieden ist, derart über den Haftvermittlerkern (2) auf das Substrat (1), daß der Haftvermittlerkern (2) von einer Schicht (3) aus dem schlecht haftenden Material umschlossen wird.

8. Verfahren nach Anspruch 7, wobei die Schritte (ii) und (iii) unter Verwendung unterschiedlicher Strukturmasken durchgeführt werden, wobei die Strukturmaskengröße in Schritt (ii) kleiner als diejenige in Schritt (iii) gewählt wird.

9. Verfahren nach Anspruch 7, wobei die Schritte (ii) und (iii) unter Verwendung gleicher Strukturmasken durchgeführt werden und Schritt (iii) nachfolgend weiter eine konforme Abscheidung von schlecht haftendem Material durchgeführt wird.

10. Verfahren zur Herstellung einer elektronischen Vorrichtung nach einem oder mehreren der vorhergehenden Ansprüche 2 bis 6, umfassend die Schritte:
(i) Bereitstellen eines Substrats (1),
(ii) Anordnen mindestens eines Haftvermittlerkerns (2) auf dem Substrat (1),
(iii) Abscheiden des schlecht haftenden Materials, das von dem Haftvermittlermaterial verschieden ist, derart über den Haftvermittlerkern (2) auf das Substrat (1), daß der Haftvermittlerkern (2) von einer Schicht (3) aus dem schlecht haftenden Material umschlossen wird,
(iv) selektives Entfernen des schlecht haftenden Materials an der dem Substrat (1) abgewandten Seite des Haftvermittlerkerns (2), so daß das Haftvermittlermaterial an der dem Substrat (1) abgewandten Seite freigelegt wird,
(v) Umsetzen des in Schritt (iv) freigelegten Haftvermittlermaterials an der dem Substrat (1) abgewandten Seite in einer reaktiven Atmosphäre unter Ausbildung einer Schicht (4) aus einem Reaktionsprodukt des Haftvermittlermaterials.

11. Verfahren nach Anspruch 10, wobei in Schritt (v) das Umsetzen des Haftvermittlermaterials in einer Sauerstoff-haltigen Atmosphäre erfolgt.

12. Verfahren nach einem oder mehreren der Ansprüche 7 bis 11, wobei das Anordnen des Haftvermittlermaterials auf das Substrat (1) bzw. das Abscheiden des schlecht haftenden Materials durch Sputtertechnik erfolgt.

13. Verfahren nach einem oder mehreren der Ansprüche 7 bis 12, wobei das Strukturieren des Haftvermittlerkerns (2) bzw. des schlecht haftenden Materials (3) durch Lift-Off-Technik oder Ätzen erfolgt.

14. Elektronische Anordnung, umfassend eine Vielzahl der Vorrichtungen nach einem der Ansprüche 1 bis 6 oder hergestellt gemäß dem Verfahren nach einem der Ansprüche 7 bis 13, wobei der Abstand der umschlossenen Haftvermittlerkerne in lateraler Richtung in einem Bereich von 20 nm bis 200 nm liegt.
